Europäisches Patentamt

**European Patent Office**

**Office européen des brevets**

(11) Publication number: **0 103 168**
A2

(12) **EUROPEAN PATENT APPLICATION**

(21) Application number: **83107887.8**

(22) Date of filing: **10.08.83**

(51) Int. Cl.³: **H 01 L 31/02, H 01 L 27/14**

(30) Priority: **10.09.82 JP 156665/82**
**16.09.82 JP 159615/82**

(43) Date of publication of application: **21.03.84**
**Bulletin 84/12**

(84) Designated Contracting States: **DE FR GB**

(71) Applicant: **HITACHI, LTD., 6, Kanda Surugadai 4-chome Chiyoda-ku, Tokyo 100 (JP)**

(72) Inventor: **Kumada, Masaharu, 3550, Hayano, Mobara-shi Chiba-ken (JP)**
Inventor: **Tanabe, Hideo, 460, Shimonagayoshi, Mobara-shi Chiba-ken (JP)**
Inventor: **Yuhara, Katsuo, 460, Shimonagayoshi, Mobara-shi Chiba-ken (JP)**
Inventor: **Misumi, Akira, 1322-7, Koshiate, Mobara-shi Chiba-ken (JP)**

(74) Representative: **Hauck, Hans, Dipl.Ing. Patentanwälte Dipl.-Ing. H. Hauck et al, Dipl.-Phys. W. Schmitz Dipl.-Ing. E. Graalfs Dipl.-Ing. W. Wehnert Dr.-Ing. W. Döring, Mozartstrasse 23 D-8000 München 2 (DE)**

(54) **Amorphous silicon solar battery.**

(57) In an amorphous silicon solar battery of the type comprising a flexible and heat resistant substrate, at least two lower electrodes formed on the substrate, an amorphous silicon film formed on the lower electrodes, and at least two upper electrodes formed on the amorphous silicon film, there is provided an inorganic insulating film provided between the substrate and the lower electrodes. The substrate is made of a resin film or a metal sheet. Where the substrate is made of a metal alloy containing Cr, the substrate is heated to selectively oxidize Cr to form a chromium oxide film which is used as a portion of the insulating film. With this construction it is possible to form a plurality of serially connected solar cells on the same substrate.

0103168

Specification

Title of the Invention

Amorphous Silicon Solar Battery

Background of the Invention

This invention relates to an amorphous silicon solar battery, and more particularly to an improvement of an insulating film structure on a substrate surface, on which are formed electrodes and an amorphous silicon film, and a method of forming the insulating film.

In recent years, a light transmitting glass plate or a stainless steel sheet is generally used as the substrate of an amorphous silicon solar battery because of their excellent properties. Each solar cell utilizing amorphous silicon has an open-circuit voltage of about 0.7V under the light of a fluorescent lamp so that when such a solar battery is used as the source of a desk top calculating device or the like small device, it is necessary to connect in series at least 3 or more cells. Where a glass plate is used as the substrate, since its surface is flat and smooth and has a sufficiently high insulating strength, it is easy to form solar cells which can be connected in series. In recent years, demand for solar batteries using flexible substrate is increasing and in such a case the glass substrate can not be used. To meet this requirement, amorphous silicon solar batteries utilizing a stainless steel sheet or a heat resistant resin film as the flexible substrate have been proposed. But these materials do not have sufficient surface flatness and smoothness necessary to provide solar batteries having excellent performances. Especially, where a stainless steel sheet is used, it is necessary to insulate the surface thereof.

To solve this problem, we have already proposed an amorphous silicon solar battery wherein a heat resistant resin film is formed on a flexible and heat resistant substrate and at least two electrodes and an amorphous silicon film are formed on the resin film so as to improve the surface flatness and the insulating strength.

Even with such improved construction, the heat resistant resin film formed on the substrate lacks reliability, especially, moisture-proof properties. More particularly, even when the electrodes and the amorphous silicon film are formed on the substrate formed with a heat resistant film, after using over a long time, the heat resistant resin film absorbs moisture or the electrode surface is oxidized, thus peeling off the electrode, whereby the electric characteristics of the solar battery are greatly degraded.

One of the reasons of the great utility of the amorphous silicon solar battery lies in that the amorphous silicon film having a large area can be formed continuously. To make use of this advantage, it is desirable to form the substrate as a continuous sheet that can be fed from a spool.

To this end, it has been tried to form the substrate of a film of a polyimide type polymer resin. However, the reliability of such resin film is not high because of its high permeability to moisture. Accordingly, it has been desired to use an inorganic substrate. Since the output voltage of an amorphous silicon solar cell is usually less than 1V, it is necessary to connect in series a number of solar cells to obtain higher output voltage but it has been difficult to form a number of cells on the same substrate.

As will be described later according to one embodiment of this invention, a stainless steel sheet is used as the substrate, but where such stainless steel sheet is used, as it has a high electroconductivity, it is impossible to electrically isolate a number of cells formed thereon. Accordingly, in order to electrically isolate and connect in series a number of cells, it is necessary to apply an electric insulating film on the stainless steel substrate before forming the amorphous silicon solar cells thereon. Such an insulating film can be formed by forming a film of $SiO_2$ or $Al_2O_3$ by sputtering, or dip process but it is difficult to form an insulating film free from pin holes and having a large area. Moreover, it is also difficult to form the insulating film having sufficient flatness.

## Summary of the Invention

Accordingly it is an object of this invention to provide an improved amorphous silicon solar battery whose electrical characteristics do not deteriorate with time.

Another object of this invention is to provide an amorphous silicon solar battery capable of preventing oxidation and peeling-off of the electrode.

Still another object of this invention is to provide a novel amorphous silicon solar battery wherein a number of electrically isolated cells can be formed on the same substrate and can be connected in series to produce a high output voltage.

A further object of this invention is to provide a method of manufacturing an amorphous silicon solar battery having an insulating film on a metallic substrate, the insulating film being free from pin holes, dense and flat and can be formed to have a large area.

According to one aspect of this invention, there is provided an amorphous silicon solar battery of the type comprising a flexible and heat resistant substrate, at least two lower electrodes formed on the substrate, an amorphous silicon film formed on the lower electrode, and at least two upper electrodes formed on the amorphous silicon film, wherein an inorganic insulating film is provided between the substrate and the lower electrodes.

According to another aspect of this invention, there is provided a method of manufacturing an amorphous silicon solar battery of the type comprising a substrate, an insulating film formed on the substrate, at least two lower electrodes formed on the insulating film, an amorphous silicon film formed on the lower electrodes, and at least two upper electrodes formed on the amorphous silicon film, the method comprising the step of forming a chromium oxide film between the substrate and the insulating film.

Where the substrate is made of an alloy containing Cr, the substrate is heated in hydrogen atmospher containing $H_2O$(water) to selectively oxidize the chromium in the alloy, thereby forming the chromium oxide film.

Brief Description of the Drawings

These and further objects and advantages of the invention can be more fully understood from the following detailed description taken in conjunction with the accompanying drawings, in which;

Fig. 1 is a plan view showing one embodiment of the amorphous silicon solar battery of this invention;

Fig. 2 is a sectional view of the solar battery taken on line II-II in Fig. 1; and

Fig. 3 is a sectional view showing a modified embodiment of this invention.

Description of the Preferred Embodiments

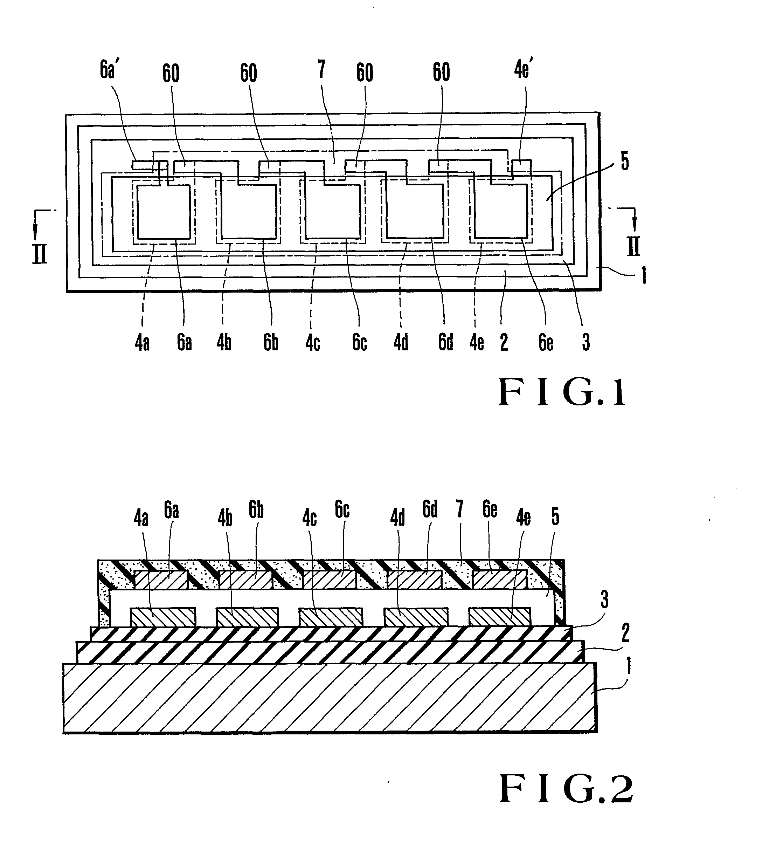

In the embodiment of this invention shown in Figs. 1 and 2, the surface of a stainless steel substrate 1 has a thickness of about 100 microns, for example, a surface roughness of less than 0.3 micron. Then, a polymer resin film 2 having a heat resistant property and a thickness of about two microns is coated on the surface of the stainless steel substrate. The polymer resin film 2 may preferably be made of polyimide resin, most preferably, polyimide iso-indroquinazolinedione (Trade mark of Hitachi Chemical Co., Ltd. abbreviated as PIQ). The resin film can be applied uniformly by a spinner spray or dip method and then baked at a high temperature of about 350°C. Alumina is then sputtered onto the resin film 2 coated on the stainless steel substrate 1 to form an inorganic insulating film 3 having a thickness of about 2000°A. Then, stainless steel is sputtered onto the inorganic insulating film to form lower electrodes 4a, 4b, 4c, 4d and 4e each having a thickness of about 2000°A and spaced a predetermined distance. Then while heating the substrate 1 to a temperature of about 250°C, an amorphous silicon film 5 is formed on the inorganic insulating film 3 to cover these lower electrodes 4a - 4e by plasma CVD process in the order of p, i and n-type layers or n, i and p-type layers. Then, $In_2O_3$ is sputtered to form spaced transparent upper electrodes 6a, 6b, 6c, 6d and 6e of about 800°A thickness on the amorphous silicon film 5 at portions opposing respective lower electrodes 4a to 4e (dotted line in Fig. 1). The upper electrode of a cell is electrically connected with the lower electrode of an adjacent cell at an end 60 thereof. Finally, $SiO_2$ is sputtered to a thickness of about 2000°A, onto the upper electrodes 6a - 6e to form a passivation film 7, thus completing 5 amorphous silicon solar cells connected in series. Serial connection of the 5 amorphous silicon solar cells is accomplished concurrently with the formation of the pattern of the upper electrodes 6a - 6e. As shown in Fig. 1, opposite outermost upper and lower electrodes have output terminals 6a' and 4e', respectively. For clarity of illustration, in the Fig. 1 plan view the passivation film 7 is illustrated by phantom line and the upper electrodes by solid line.

As described above, according to this invention, the upper surface of the stainless steel substrate 1 is coated with the heat resistant resin film 2 and a moisture proof inorganic insulating film 3 is formed on the resin film 2. Consequently, the substrate is provided with sufficiently flat and smooth surface, and the lower electrodes 4a - 4e are perfectly protected against moisture. Consequently, with the solar battery of this invention, an open-circuit voltage of about 3.3V and a short-circuit current of about 18 A were obtained under the light of about 200 lux emitted by a fluorescent lamp. The open-circuit voltage of each cell (having a light receiving area of $1cm^2$) was about 0.66V and no loss caused by poor insulation between adjacent cells was noted. Since inorganic insulating film 3 is formed on the heat resistant insulating film 2, no oxidation and peeling-off of the lower electrodes 4a - 4e was noted after a moisture proof test over about 1,000 hours at a temperature of about 70°C and a relative humidity of about 95% and any deterioration of the electric characteristics was noted.

Although in the foregoing embodiment a sputtered alumina film was used as the inorganic insulating film 3 alumina can be substituted by silicon nitride ($SiN_x$), amorphous silicon, or silicon dioxide $SiO_2$. Instead of sputtering, the inorganic insulating film 3 can also be formed by vapor deposition, ion implantation on plasma CVD method. Furthermore, the thickness of the film 3 is not limited to 2000°A but may be in a range of from 2000°A to 5 microns. With a film thickness of less than 200°A, sufficient moisture-proof properties can not be obtained, whereas a film thickness of larger than 5 microns does not provide any additional advantage. Consequently, a thickness of about 2000°A is most suitable for providing sufficiently high moisture proof properties and high productivity.

Furthermore, in the foregoing embodiment, a stainless steel substrate having a thickness of about 100 microns was used as a flexible and heat resistant substrate on which an amorphous silicon film is formed, but a metal substrate having a thickness of about 100 microns, for example, a sheet of Fe-Ni alloy, can be used. Furthermore, even when Kapton (Trade mark) of polyamide type is used as the heat resistant insulating film, the same advantageous effects can also be obtained. The thickness of the substrate is not limited to 100 microns.

The thickness of the heat resistant resin film 2 formed on the substrate is not limited to 2 microns but may be in a range of from 0.1 to 100 microns depending upon the thickness of the substrate. With a film thickness of less than 0.1 micron, sufficient insulating strength can not be obtained whereas with a film thickness of larger than 100 microns, the film has a tendency to peel off when it is bent. From the standpoint of film characteristic and productivity, an optimum range is 2 to 10 microns.

According to this embodiment, since an inorganic insulating film is formed on a flexible and heat resistant substrate on which an amorphous silicon film and electrodes are formed, no peeling-off and oxidation of the electrodes occurs so that deterioration with time of the electric characteristics can be efficiently prevented, thereby providing an amorphous silicon solar battery having high reliability, high quality and high performances.

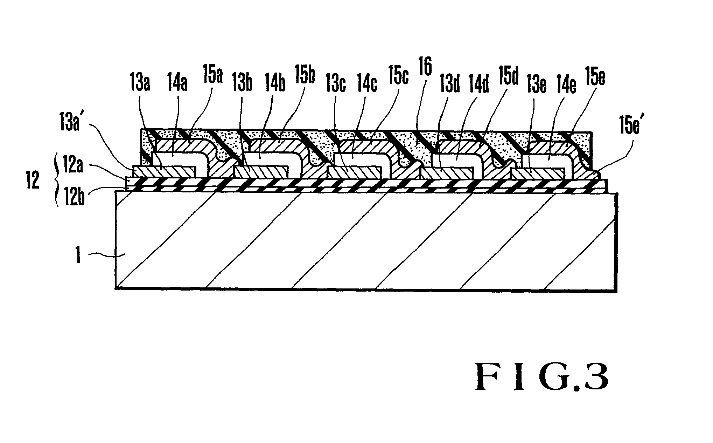

Fig. 3 is a sectional view showing an amorphous silicon solar battery prepared by the method of this invention. The solar battery shown in Fig. 3 comprises a thin metal substrate 10 containing Cr and having a thickness of about 100 microns, and an insulating film 12a of $SiO_2$ having a smooth surface and formed by sputtering $SiO_2$ to a thickness of about 5000°A. Then the substrate formed with the $SiO_2$ film is placed for 30 minutes in hydrogen atmosphere having a dew point of 0°C, and maintained at a temperature of about 850°C for selectively oxidizing only Cr contained in the stainless steel substrate to form a chromium oxide film 12b on the surface of the substrate 10. Thus, the insulating film 12 comprises the lower chromium oxide layer 12b and the upper $SiO_2$ layer 12a having a smooth and flat surface. Then, stainless steel is sputtered onto the insulating film 12 to a thickness of about 2000°A to form lower electrodes 13a - 13e at a predetermined spacing. Then, while heating the substrate 10 to a temperature of about 250°C, amorphous silicon films 14a - 14e each having a 300°A p-conductivity layer, a 5000°A i-type layer and a 100°A n-conductivity layer are formed on the lower electrodes 13a - 13e, respectively. Then, $In_2O_3$-$SnO_2$ is sputtered on the amorphous silicon films 14a - 14e to form transparent upper electrodes 15a - 15e having a thickness of about 800°A, each upper electrode terminating in electrical connection at an end of an adjacent lower electrode. Then $SiN_x$ is sputtered onto the upper electrodes 15a - 151 to a thickness of about 2000°A to form a passivation $SiN_x$ film 16 thus completing 5 serially

connected amorphous silicon cells. Mutual connection of these cells are formed concurrently with the formation of the pattern of the upper electrodes 15a - 15e. Output terminals, 13a' and 15e' are respectively provided for the outermost lower electrode 13a and upper electrode 15e.

The amorphous silicon solar battery thus formed were found to produce an open-circuit voltage five times as large as that of one cell.

For comparison, only a chromium oxide film was used as the insulating film between an amorphous silicon film and a stainless steel substrate whereas the other elements were prepared in the same manner as in Fig. 3, and the open-circuit voltage of a control amorphous silicon solar battery thus prepared was measured under light. Some of the control solar cells showed an open-circuit voltage about five times as large as that of a single conventional amorphous silicon solar cell but others showed lesser open-circuit voltage.

Although in the embodiment shown in Fig. 3 a stainless steel substrate containing Cr was described, the substrate may be made of a Fe-Ni-Cr alloy or a Fe-Cr alloy or a Ni-Cr alloy.

Furthermore, in the embodiment shown in Fig. 3, prior to the heat treatment in $H_2$ atmosphere containing $H_2O$, a $SiO_2$ or a chromium oxide insulating film was formed on the substrate by sputtering, the insulating film may be made of $Al_2O_3$ or Si Nx by vapor deposition, plasma CVD process or the like.

Thus, in the embodiment shown in Fig. 3, an insulating film consisting of a chromium oxide film and a metal oxide film was formed on a thin metal substrate so that it is possible to form an excellent insulating film having a large area, sufficient flatness and high density.

What is claimed is:

1.      In an amorphous silicon solar battery of the type comprising a flexible and heat resistant substrate, at least two lower electrodes formed on said substrate, an amorphous silicon film formed on said lower electrodes, and at least two upper electrodes formed on said amorphous silicon film, the improvement which comprises an inorganic insulating film provided between said substrate and said lower elctrodes.

2.      The amorphous silicon solar battery according to claim 1 which further comprises a heat resistant resin film provided between said substrate and said inorganic insulating film.

3.      The amorphous silicon solar battery according to claim 1 wherein said substrate is made of a metal sheet and a heat resistant resin thereon.

4.      The amorphous silicon solar battery according to claim 1 wherein said substrate is made of an alloy containing chromium and said solar battery further comprises a film of chromium oxide between said substrate and said inorganic insulating film.

5.      A method of manufacturing an amorphous silicon solar battery of the type comprising a substrate, an insulating film formed on said substrate, at least two lower electrodes formed on said insulating film, an amorphous silicon film formed on said lower electrodes, and at least two upper electrodes formed on said amorphous silicon film, the method comprising the step of forming a chromium oxide film between said substrate and said insulating film.

6. The method according to claim 5 wherein said substrate comprises an alloy containing chromium, and said chromium oxide film is formed by heating said substrate to selectively oxidize chromium in said substrate.

7. The method according to claim 6 wherein said heating is carried out in hydrogen atmosphere containing water.

F I G.1

F I G.2

FIG.3